Europäisches Patentamt

European Patent Office

Office européen des brevets

(19)

(11) Numéro de publication: **0 258 100 B1**

(12) FASCICULE DE BREVET EUROPEEN

(45) Date de publication de fascicule du brevet:
16.10.91

(51) Int. Cl.⁵: **H03G 7/00**

(21) Numéro de dépôt: 87401755.1

(22) Date de dépôt: 28.07.87

(54) **Dispositif de régulation de la puissance crête fournie par la chaîne d'amplification d'un émetteur radioélectrique.**

(30) Priorité: 05.08.86 FR 8611332

(43) Date de publication de la demande:
02.03.88 Bulletin 88/09

(45) Mention de la délivrance du brevet:
16.10.91 Bulletin 91/42

(84) Etats contractants désignés:
DE GB IT

(56) Documents cités:
EP-A- 0 172 042
FR-A- 2 469 051
US-A- 3 918 003

PATENT ABSTRACTS OF JAPAN, vol. 8, no.
142 (E-254)[1579], 3 juillet 1984; & JP-A-59 51
630 (SONY K.K.) 26-03-1984

(73) Titulaire: THOMSON-CSF
51, Esplanade du Général de Gaulle
F-92800 Puteaux(FR)

(72) Inventeur: Guais, Noel
THOMSON-CSF SCPI 19, avenue de Messine
F-75008 Paris(FR)
Inventeur: Boisumeau, Guy
THOMSON-CSF SCPI 19, avenue de Messine
F-75008 Paris(FR)
Inventeur: Robert, Pierre
THOMSON-CSF SCPI 19, avenue de Messine
F-75008 Paris(FR)

(74) Mandataire: Lincot, Georges et al
THOMSON-CSF SCPI
F-92045 PARIS LA DEFENSE CEDEX 67(FR)

## Description

La présente invention concerne un dispositif de régulation de la puissance crête fournie par la chaîne d'amplification d'un émetteur radioélectrique.

Elle s'applique notamment à la réalisation de compresseurs dans les émetteurs à bande latérale unique où l'on cherche à obtenir en permanence, quelque soit l'amplitude des signaux à amplifier, une puissance crête en sortie de l'émetteur qui soit aussi proche que possible de la puissance crête maximale admissible.

Un exemple de réalisation de ces compresseurs est par exemple décrit dans la demande de brevet français FR-A 2 469 051 déposée au nom de la Demanderesse. Dans cet exemple, le compresseur est constitué principalement par un atténuateur variable couplé à une chaîne d'émission et à un circuit de commande. Le rapport d'atténuation de l'atténuateur est modifié par le circuit de commande en fonction du signal à amplifier pour provoquer une variation de gain globale du circuit formé par l'atténuateur et la chaîne d'amplification en sens inverse de la variation de niveau du signal appliqué sur l'atténuateur.

Si les émetteurs fonctionnant suivant ce principe absorbent efficacement les pointes de puissance provoquées par les variations de l'amplitude des signaux vocaux à transmettre, ils présentent l'inconvénient d'avoir un circuit de commande toujours actif qui applique en permanence sur l'entrée de l'atténuateur une ondulation de tension résiduelle quelque soit le niveau de puissance fourni par l'émetteur. Cette ondulation provoque une modulation d'amplitude parasite dont les bandes latérales viennent s'ajouter aux raies d'intermodulation dues aux non-linéarités des circuits d'amplification et qui contribuent à une dégradation importante de la linéarité de l'ensemble.

Le but de l'invention est de pallier les inconvénients précités.

A cet effet, l'invention a pour objet un dispositif de régulation de la puissance crête fournie par la chaîne d'amplification d'un émetteur radioélectrique du type comprenant un atténuateur variable principal placé en série avec la chaîne d'amplification, couplé à un circuit de commande du niveau d'atténuation de l'atténuateur pour maintenir à un niveau à peu près constant la puissance crête du signal fourni par la chaîne d'amplification indépendamment de l'amplitude du signal d'entrée à amplifier, caractérisé en ce qu'il comprend un circuit de différentiation du signal d'entrée couplé à l'atténuateur variable par l'intermédiaire d'un circuit inhibiteur pour anticiper l'action du circuit de commande sur l'atténuateur variable principal et commander le rapport d'atténuation de l'atténuateur variable lorsque la vitesse de croissance de l'amplitude du signal d'entrée est supérieure à un seuil de croissance déterminé.

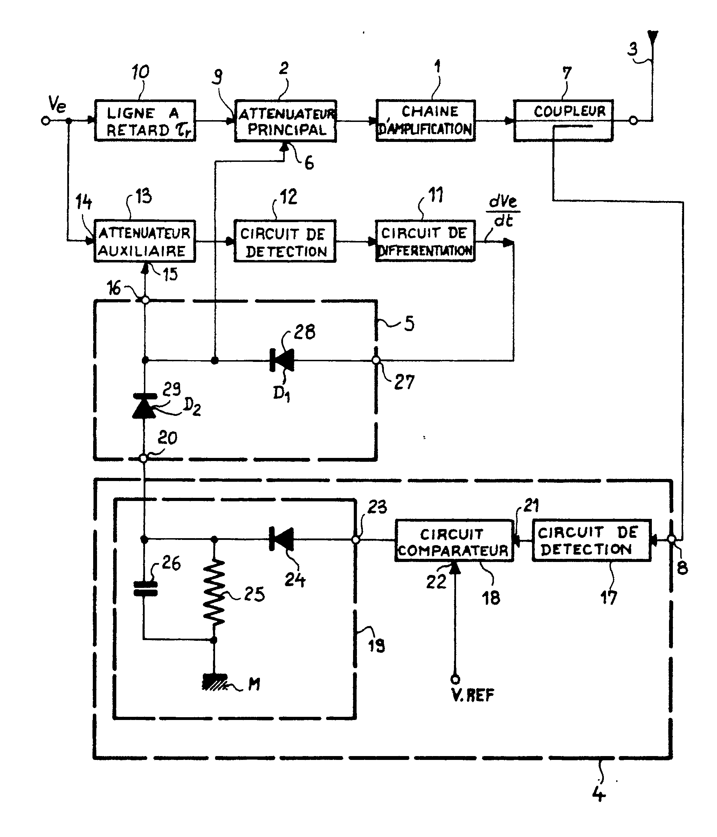

L'invention sera mieux comprise et d'autres caractéristiques apparaîtront à l'aide de la description ci-après et du dessin s'y rapportant qui représente le schéma d'un dispositif de régulation de la puissance moyenne d'un émetteur selon l'invention.

L'émetteur qui est représenté comprend une chaîne d'amplification 1 et éventuellement de transposition de fréquence interconnectée entre un atténuateur principal 2 et une antenne d'émission 3. L'atténuateur principal 2 est commandé à partir d'un circuit de commande 4 représenté à l'intérieur d'une ligne en pointillés, ainsi que d'un circuit inhibiteur 5 représenté également à l'intérieur d'une ligne en pointillés, réalisant le couplage du circuit de commande 4 à une entrée de commande 6 de l'atténuateur principal 2. Un coupleur 7 prélève une partie de la puissance fournie par la chaîne d'amplification 1 pour l'appliquer à une entrée 8 du circuit de commande 4. Le signal $V_e$ à amplifier et à transmettre sur l'antenne 3 est appliqué à l'entrée 9 de l'atténuateur principal 2 au travers d'une ligne à retard 10. L'émetteur représenté comprend également un circuit de différentiation 11 qui reçoit sur une entrée le signal $V_e$ à amplifier au travers d'un circuit de détection 12 et d'un atténuateur auxiliaire 13 dont une entrée de signal 14 reçoit le signal $V_e$ à amplifier. L'atténuateur auxiliaire 13 possède également une entrée de commande 15 qui est reliée à une sortie 16 du circuit inhibiteur 5, cette sortie étant reliée également à l'entrée de commande 6 de l'atténuateur principal 2.

Le circuit de commande 4 comprend un circuit de détection 17, un circuit comparateur 18, et une cellule de resensibilisation 19 représentés à l'intérieur d'une ligne en pointillés, les circuits 17, 18 et 19 étant reliés dans cet ordre en série entre l'entrée de commande 8 du circuit de commande 4 et une entrée 20 du circuit inhibiteur 5. Le circuit comparateur 18 possède une première entrée 21 qui est reliée à une sortie du circuit de détection 17 et une deuxième entrée 22 sur laquelle est appliquée une tension de référence VREF. Le résultat de la comparaison effectuée par le circuit comparateur 18 est appliqué sur une entrée 23 de de la cellule de resensibilisation 19 qui est composée d'une diode 24 et d'un circuit constitué par une résistance 25 et un condensateur 26 montés tous les deux en parallèle entre une extrémité de la diode 24 et le point de masse M de référence des signaux. La diode 24 est reliée par ses extrémités entre l'entrée 20 du circuit inhibiteur 5 et à l'entrée 23 du circuit 19. Ce circuit permet de retarder la resensibilisation de l'atténuateur 2 suite à une diminution de l'amplitude du signal d'entrée $V_e$ . Le

circuit inhibiteur 5 comprend une deuxième entrée 27 qui est reliée à la sortie du circuit de différentiation 11.

L'analyse du fonctionnement du dispositif qui vient d'être décrit est exposé ci-après selon une première hypothèse où l'on suppose que le dispositif est privé du circuit de différentiation 11 et ne fonctionne qu'avec la boucle de régulation formée par le circuit de commande 4, le coupleur 7 et l'atténuateur principal 2 et selon une deuxième hypothèse où l'on introduit l'action du circuit de différentiation et du circuit d'inhibition 5 dans le fonctionnement général du dispositif.

Selon la première hypothèse le circuit de commande 4 compare en permanence à l'aide du circuit comparateur 18 le signal appliqué par le coupleur 7 sur l'entrée 8 du circuit de commande 4 et transmis au travers du circuit de détection 17, à une tension de référence stable VREF. Les écarts entre la tension fournie par le circuit de détection 17 et la tension de référence VREF sont transmis à l'entrée 6 de l'atténuateur principal 2 au travers de la cellule de resensibilisation 19. L'atténuateur principal 2 modifie son rapport d'atténuation pour annuler l'écart de tension fourni par le circuit comparateur 18 et réalise ainsi une stabilisation de la puissance fournie par la chaîne d'amplification 1 de l'émetteur.

Ce circuit s'il permet d'obtenir une régulation valable de la puissance en régime établi, ne peut par contre éviter les surcharges de courte durée dues à des variations rapides du signal d'entrée. En effet, si l'on applique à l'entrée du système un créneau d'amplitude importante avec un temps de montée très bref on obtiendra sur la sortie antenne de l'émetteur une puissance nettement supérieure à la puissance nominale. Cette surcharge persistera jusqu'à ce que la chaîne de régulation réagisse soit pendant la somme des temps de réponse des circuits de détection 17, de comparaison 18, et d'atténuation 2.

Ces surcharges présentent les inconvénients qu'elles risquent de dégrader des étages de puissance HF, qu'elles peuvent occasionner la destruction des circuits alimentés par l'émetteur, ou encore si elles sont fréquentes ou présentent un caractère périodique, de constituer une signature du matériel et donc de son utilisateur, du fait que l'amplificateur est saturé pendant la durée de la surcharge et qu'il est alors susceptible de générer des raies parasites. Ce défaut est corrigé, comme l'explique le mode de fonctionnement décrit ci-après, selon la deuxième hypothèse où l'on introduit le circuit de différentiation 11 et le circuit inhibiteur 5 dans la boucle de régulation. Selon cette deuxième hypothèse le paramètre choisi pour corriger les surcharges n'est plus l'amplitude du signal d'entrée $V_e$ mais sa vitesse de croissance

$$\frac{dV_e}{dT}$$

fournie par le circuit de différentiation 5. Ce choix est justifié par le fait que la boucle de régulation comprenant le circuit de commande 4 et l'atténuateur principal 2 est parfaitement capable d'absorber de grandes variations d'amplitude, à condition que la vitesse de montée du signal $V_e$ soit inférieure à une vitesse critique qui est fonction des temps de réponse des divers circuits constituant la boucle de régulation, c'est-à-dire, du circuit de détection 17, du circuit de comparaison 18 et de l'atténuateur principal 2. Dans le mode de fonctionnement qui correspond à la deuxième hypothèse, l'atténuateur auxiliaire 13 reçoit directement sur son entrée 14 le signal à amplifier $V_e$ et le transmet au travers du circuit de détection 12 au circuit de différentiation 11 qui fournit sur sa sortie une tension significative lorsque la vitesse de croissance du signal $V_e$ est plus grande que la vitesse critique. Le circuit inhibiteur 5 assure alors les connexions de l'atténuateur principal 2 et de l'atténuateur auxiliaire 13 alternativement, soit à la sortie du circuit de différentiation, ou soit à la sortie du circuit de commande 4 suivant que cette tension issue de

$$\frac{dV_e}{dT}$$

fournie par le circuit de différentiation 11 est supérieure ou inférieure à celle fournie par le circuit de commande 4.

Lorsque, la variation du signal

$$\frac{dV_e}{dT}$$

est inférieure à la vitesse critique, l'atténuateur principal 2 est commandé par le circuit de commande 4 au travers de la diode 29. Dans ce cas, correspondant à des signaux à transmettre normaux, le circuit de différentiation 11 est déconnecté de la commande des atténuateurs variables par la diode 28. Comme le niveau du signal appliqué sur l'entrée 27 du circuit d'inhibition 5 est inférieur au niveau de celui appliqué sur son entrée 20 il n'y a plus de risque de provoquer une modulation parasite du signal comme dans le cas des dispositifs de type semblable à celui décrit dans la demande de brevet précédemment citée. Dans ce type de circuit, la tension de commande qui est appliquée à l'entrée 6 de l'atténuateur principal 2 présente toujours une ondulation qui suit les variations du signal d'entrée. Cette ondulation est amplifiée par la chaîne d'amplification 1 et provoque une modulation d'amplitude parasite dont les bandes latérales viennent s'ajouter aux raies d'intermodulations dues aux non-linéarités de la chaîne d'amplification 1.

Par contre, lorsque la variation du signal

$$\frac{dV_e}{dT}$$

est supérieure à la vitesse critique, l'atténuateur principal 2 est commandé par le circuit de différentiation 11. Le circuit de différentiation 11 agit alors seul, au travers de la diode 28, sur l'atténuateur 2 qui réduit le gain de l'ensemble des éléments formés par l'atténuateur 2 et la chaîne d'amplification 1 avant l'arrivée du signal utile sur l'entrée 9 de l'atténuateur principal 2, le temps de propagation de la ligne à retard 10 étant supérieur ou égal à la somme des temps de réponse des circuits de détection 12, de différentiation 11, et d'atténuation 2. Après l'action du circuit de différentiation l'atténuateur principal 2 et le circuit de commande 4 prennent le relais et ajustent le gain pour obtenir la puissance nominale normale de fonctionnement de l'émetteur.

Le rôle de l'atténuateur auxiliaire 13 est d'ajuster l'efficacité du circuit différentiateur 11, en fonction du niveau de puissance en sortie de l'émetteur.

En l'absence de signal, le gain de la chaîne d'amplification est maximum, d'où la nécessité d'agir rapidement, en cas d'application d'un signal $V_e$ de montée rapide.

Par contre, en régime établi, le gain de la chaîne principale est réduit par l'action de l'atténuateur principal 2 commandé par le circuit comparateur 4, et dans ce cas une trop grande sensibilité du circuit de différentiation 11 ne permettrait pas de le déconnecter efficacement.

## Revendications

1. Dispositif de régulation de la puissance crête fournie par la chaîne d'amplification (1) d'un émetteur radioélectrique du type comprenant un atténuateur variable principal (2) placé en série avec la chaîne d'amplification (1), couplé à un circuit de commande (4) du niveau d'atténuation de l'atténuateur (2) pour maintenir à un niveau à peu près constant la puissance crête du signal fourni par la chaîne d'amplification indépendamment de l'amplitude du signal d'entrée à amplifier, caractérisé en ce qu'il comprend un circuit de différentiation (11) du signal d'entrée couplé à l'atténuateur variable principal (2) par l'intermédiaire d'un circuit inhibiteur (5) pour anticiper l'action du circuit de commande (4) sur l'atténuateur variable principal (2) et commander le rapport d'atténuation de l'atténuateur variable (2) lorsque la vitesse de croissance de l'amplitude du signal d'entrée est supérieure à un seuil de croissance déterminé et déconnecter l'action du circuit de différentiation (11) lorsque la vitesse de croissance du signal d'entrée est inférieure à ce même seuil.

2. Dispositif selon la revendication 1, caractérisé en ce que le signal d'entrée à amplifier est appliqué au circuit de différentiation (11) au travers d'un deuxième atténuateur variable (13) dont le rapport d'atténuation est commandé par le signal différencié fourni par le circuit de différentiation (11) lorsque le circuit inhibiteur inhibe le circuit de commande.

3. Dispositif selon les revendications 1 et 2, caractérisé en ce que le rapport d'atténuation du deuxième atténuateur variable (13) est commandé par le circuit de commande (4) lorsque le circuit de différentiation est inhibé par le circuit inhibiteur (5).

4. Dispositif selon l'une quelconque des revendications 1 à 3, caractérisé en ce que le circuit de commande (4) comprend un circuit comparateur (18) pour comparer le niveau du signal fourni par la chaîne d'amplification (1) à un niveau de signal de référence prédéterminé et augmenter le rapport d'atténuation de l'atténuateur variable principal (2) lorsque le niveau du signal fourni par la chaîne d'amplification (1) est supérieur au niveau du signal de référence et diminuer son rapport d'atténuation dans le cas contraire.

5. Dispositif selon l'une quelconque des revendications 2 à 4, caractérisé en ce que les moyens inhibiteurs (5) comprennent une première diode (28) et une deuxième diode (29) reliées chacune par une première extrémité à une entrée de commande (6, 15) des premier et deuxième atténuateurs (2, 13) et par une deuxième extrémité (27, 20) respectivement à une sortie de signal du circuit de différentiation (11) et une sortie de signal du circuit de commande (4).

6. Dispositif selon l'une quelconque des revendications 1 à 5, caractérisé en ce que le signal à amplifier est appliqué à l'entrée de la chaîne d'amplification (11) au travers de l'atténuateur variable principal (2).

7. Dispositif selon l'une quelconque des revendications 1 à 6, caractérisé en ce qu'il comprend une ligne à retard (10) placée en série avec l'atténuateur variable principal (21) et la chaîne d'amplification (1) pour retarder l'application du signal à amplifier sur l'atténuateur variable principal (2) par rapport à son application sur le deuxième atténuateur (13).

## Claims

1. A device for regulating the peak power supplied by the amplifier chain (1) of a radio transmitter, comprising a variable main attenuator (2) mounted in series with the amplifier chain (1) and coupled to a control circuit (4) for controlling the attenuation rate of the attenuator (2) in order to maintain an approximately constant peak power level of the signal supplied by the amplification chain regardless of the amplitude of the input signal to be amplified, characterized in that it comprises a circuit (11) for differentiating the input signal, this circuit being coupled to the variable main attenuator (2) via an inhibition circuit (5) in order to inhibit the effect of the control circuit (4) on the main variable attenuator (2) and to control the attenuation rate of the variable attenuator (2), if the rise speed of the input signal amplitude exceeds a predetermined rise speed threshold, and to disconnect the action of the differentiation circuit (11), if the rise speed of the input signal is below this threshold.

2. A device according to claim 1, characterized in that the input signal to be amplified is applied to the differentiating circuit (11) via a second variable attenuator (13) whose attenuation rate is controlled by the differentiated signal supplied by the differentiating circuit (11), if the inhibition circuit inhibits the control circuit.

3. A device according to claims 1 and 2, characterized in that the attenuation rate of the second variable attenuator (13) is controlled by the control circuit (4), if the differentiating circuit is inhibited by the inhibiting circuit (5).

4. A device according to any one of claims 1 to 3, characterized in that the control circuit (4) comprises a comparator circuit (18) for comparing the level of the signal supplied by the amplifier chain (1) to a predetermined reference signal level in order to increase the attenuation rate of the variable main attenuator (2), if the level of the signal supplied by the amplifier chain (1) exceeds the reference signal level, and to decrease its attenuation rate in the inverse case.

5. A device according to any one of claims 2 to 4, characterized in that the inhibiting means (5) comprise a first diode (28) and a second diode (29), one terminal of each diode being connected to the control input (6, 15) of the first and second attenuators (2, 13 respectively) and a second terminal (27, 20) thereof being connected respectively to a signal output of the differentiating circuit (11) and to a signal output of the control circuit (4).

6. A device according to any one of claims 1 to 5, characterized in that the signal to be amplified is applied to the input of the amplifier chain (1) via the variable main attenuator (2).

7. A device according to any one of claims 1 to 6, characterized in that it comprises a delay line (10) mounted in series with the variable main attenuator (2) and the amplifier chain (11) in order to delay the application of the signal to be amplified to the variable main attenuator (2) with respect to its application to the second attenuator (13).

## Patentansprüche

1. Regelvorrichtung für die Spitzenleistung, die von der Verstärkungskette (1) eines Funksenders geliefert wird, mit einem veränderbaren Hauptdämpfungsglied (2), das mit der Verstärkungskette (1) in Reihe angeordnet ist und an einen Steuerkreis (4) für die Steuerung des Dämpfungswerts des Dämpfungsglieds (2) gekoppelt ist, um einen angenähert konstanten Pegel der Spitzenleistung des von der Verstärkungskette gelieferten Signals unabhängig von der Amplitude des zu verstärkenden Eingangssignals einzuhalten, dadurch gekennzeichnet, daß die Vorrichtung einen Kreis (11) zum Differenzieren des Eingangssignals aufweist, der an das veränderbare Hauptdämpfungsglied (2) über einen Inhibitionskreis (5) gekoppelt ist, um die Wirkung des Steuerkreises (4) auf das veränderbare Hauptdämpfungsglied (2) zu unterdrücken und den Dämpfungsfaktor des veränderbaren Dämpfungsglieds (2) zu steuern, wenn die Anstiegsgeschwindigkeit der Amplitude des Eingangssignals größer als eine gegebene Anstiegsgeschwindigkeitsschwelle ist, und um die Wirkung des Differenzierkreises (11) zu unterdrücken, wenn die Anstiegsgeschwindigkeit des Eingangssignals unterhalb dieser Schwelle liegt.

2. Vorrichtung nach Anspruch 1, dadurch gekennzeichnet, daß das zu verstärkende Eingangssignal an den Differenzierkreis (11) über ein zweites veränderbares Dämpfungsglied (13) angelegt ist, dessen Dämpfungsfaktor vom differenzierten Signal gesteuert wird, das vom Differenzierkreis (11) geliefert wird, wenn der Inhibitionskreis die Wirkung des Steuerkreises unterdrückt.

3. Vorrichtung nach den Ansprüchen 1 und 2, dadurch gekennzeichnet, daß der Dämpfungsfaktor des zweiten veränderbaren Dämpfungsglieds (13) vom Steuerkreis (4) gesteuert wird, wenn der Differenzierkreis durch den Inhibitionskreis (5) unwirksam gemacht ist.

4. Vorrichtung nach einem beliebigen der Ansprüche 1 bis 3, dadurch gekennzeichnet, daß der Steuerkreis (4) einen Komparator enthält, der den Pegel des von der Verstärkungskette (1) gelieferten Signals mit einem vorgegebenen Bezugssignalpegel vergleicht und den Dämpfungsfaktor des veränderbaren Hauptdämpfungsglieds (2) erhöht, wenn der Pegel des von der Verstärkungskette (1) gelieferten Signals größer als der Bezugssignalpegel ist, sowie im entgegengesetzten Fall seinen Dämpfungsfaktor verringert.

5. Vorrichtung nach einem beliebigen der Ansprüche 2 bis 4, dadurch gekennzeichnet, daß die Inhibitionsmittel (5) eine erste Diode (28) und eine zweite Diode (29) aufweisen, die mit einem ersten Anschluß an einen Steuereingang (6 bzw. 15) des ersten bzw. zweiten Dämpfungsglieds (2 bzw. 13) und mit einem zweiten Anschluß (27 bzw. 20) an einen Signalausgang des Differenzierkreises (11) bzw. einen Signalausgang des Steuerkreises (4) angeschlossen sind.

6. Vorrichtung nach einem beliebigen der Ansprüche 1 bis 5, dadurch gekennzeichnet, daß das zu verstärkende Signal an den Eingang der Verstärkungskette (1) über das veränderbare Hauptdämpfungsglied (2) angelegt ist.

7. Vorrichtung nach einem beliebigen der Ansprüche 1 bis 6, dadurch gekennzeichnet, daß sie eine Verzögerungsleitung (10) aufweist, die in Serie mit dem veränderbaren Hauptdämpfungsglied (2) und der Verstärkungskette (1) angeordnet ist, um das zu verstärkende Signal am Eingang des veränderbaren Hauptdämpfungsglieds (2) im Vergleich zum Eingang des zweiten Dämpfungsglieds (13) zu verzögern.